# EUROPÄISCHE PATENTSCHRIFT

(11) **EP 3 600 697 B1**
(45) Veröffentlichungstag und Bekanntmachung des Hinweises auf die Patenterteilung: **12.05.2021**
(21) Anmeldenummer: 18713223.8
(22) Anmeldetag: 23.03.2018
(51) Int. Cl.: B06B 1/06, G10K 11/00

(54) **SCHALLWANDLER, MIT IN SCHWINGFÄHIGE MEMBRAN INTEGRIERTEM WANDLERELEMENT MIT ELEKTRISCH AKTIVEM POLYMER**
SOUND TRANSDUCER, HAVING A DIAPHRAGM THAT IS INTEGRATED IN A MEMBRANE THAT CAN VIBRATE AND HAS AN ELECTRICALLY ACTIVE POLYMER
TRANSDUCTEUR ACOUSTIQUE COMPRENANT UN ÉLÉMENT TRANSDUCTEUR INTÉGRÉ DANS UNE MEMBRANE OSCILLANTE ET COMPORTANT UN POLYMÈRE ÉLECTROACTIF

(30) Priorität: 30.03.2017 DE 102017205376
(43) Veröffentlichungstag der Anmeldung: 05.02.2020
(73) Patentinhaber: Robert Bosch GmbH, 70442 Stuttgart (DE)
(72) Erfinder: LIEBLER, Marko, 75015 Bretten (DE); HENNEBERG, Johannes, 71093 Weil Im Schoenbuch (DE); GERLACH, Andre, 71229 Leonberg-Hoefingen (DE)
(86) Internationale Anmeldenummer: PCT/EP2018/057484
(87) Internationale Veröffentlichungsnummer: WO 2018/177943

(56) Entgegenhaltungen:
- WO-A1-2016/143469
- DE-A1-102012 208 059
- DE-A1-102013 211 533
- DE-A1-102015 110 939
- US-A- 4 725 994

## Beschreibung

Die Erfindung betrifft einen Schallwandler umfassend einen Membrantopf, ein Wandlerelement und ein Gehäuse, wobei der Membrantopf eine Membran und eine Wandung aufweist.

### Stand der Technik

Ultraschallsensoren werden unter anderem in Automobil- und Industrieanwendungen zur Erfassung des Umfelds eingesetzt. Objekte in der Umgebung können erkannt werden, indem durch den Ultraschallsensor ein Ultraschallsignal ausgesendet wird und das von einem Objekt reflektierte Ultraschallecho wieder empfangen wird. Aus der Laufzeit zwischen dem Aussenden des Ultraschallsignals und dem Empfangen des Ultraschallechos sowie der bekannten Schallgeschwindigkeit kann dann die Entfernung zu dem Objekt berechnet werden.

Die Ultraschallsensoren umfassen typischerweise einen Schallwandler mit einer Membran, einem Wandlerelement und einem Gehäuse. Bei dem Wandlerelement handelt es sich beispielsweise um ein piezokeramisches Element, welches nach Anlegen einer elektrischen Spannung die Membran in eine Schwingung versetzt bzw. zum Empfangen von Ultraschallechos die vom Schalldruck vor der Membran angeregten Schwingungen auf der Membran in ein elektrisches Signal umwandelt. Derartige Schallwandler sind im Stand der Technik bekannt, siehe hierzu beispielsweise DE 10 2012 201884 A1.

Die Verbindung zwischen dem piezokeramischen Element und dem Membranboden erfolgt üblicherweise durch einen Klebeprozess. Dieser ist sowohl im Herstellungsprozess als auch im Betrieb anfällig gegen Ausfall.

Die funktionale Gruppe des Ultraschallsensors und das Gehäuse werden als getrennte Einzelteile gefertigt und anschließend gefügt.

DE 10 2013 222 076 A1 beschreibt einen Schallwandler, der einen Resonator mit mindestens einem piezoelektrischen Element aufweist. Der Resonator ist einteilig als Membrantopf mit einer Membran und einer umlaufenden Mantelfläche aus dem gleichen Material ausgebildet. Der Membrantopf ist beispielsweise aus einem Polymermaterial wie Polyvinylidenfluorid (PVDF) oder einem piezokeramischen Material hergestellt. Ein oder mehrere Bereiche der Membran werden polarisiert, so dass piezoelektrisch aktive Bereiche ausgebildet werden.

Aus der WO 2016/143469 A1 ist ein Lautsprecher bekannt, bei dem zur Schallwandlung ein Folienelement aus einem ein elektrisch aktiven Polymer aufweist. Der zugehörige Schallwandler umfasst ein Gehäuse, ein Rahmenelement und ein Folienelement. Das Folienelement ist auf den Rahmen aufgespannt.

Aus der US 4,725,994 A ist ein Ultraschallwandler bekannt, der einen piezoelektrischen Polymerfilm enthält, der in mindestens zwei Schichten gefaltet ist und auf seinen beiden Oberflächen Elektroden aufweist. Der Ultraschallwandler reagiert auf ein Signal, das über Elektroden angelegt wird, um eine Ultraschallwelle zu erzeugen, die auf einen Punkt fokussiert wird, so dass sie in ein elektrisches Signal umgewandelt wird. In diesem Ultraschallwandler werden auf und entlang des gefalteten Bereichs des piezoelektrischen Polymerfilms eine Nut oder Durchgangslöcher gebildet.

Der Erfindung liegt davon ausgehend die Aufgabe zugrunde, einen Schallwandler mit vereinfachtem Herstellungsverfahren und einem vereinfachten Aufbau anzugeben.

### Offenbarung der Erfindung

Die Erfindung umfasst einen Schallwandler für einen Ultraschallsensor nach dem unabhängigen Anspruch 1, einen Ultraschallsensor nach Anspruch 12, sowie ein Verfahren zur Herstellung einer funktionalen Gruppe eines Schallwandlers nach dem unabhängigen Anspruch 8. Die abhängigen Ansprüche umfassen bevorzugte Ausführungsformen der Erfindung.

Gemäß der Erfindung wird ein Schallwandler für einen Ultraschallsensor vorgeschlagen. Der Schallwandler weist eine funktionale Gruppe auf, wobei die funktionale Gruppe einen Membrantopf und mindestens ein elektroakustisches Wandlerelement umfasst. Außerdem weist der Schallwandler ein Gehäuse auf. Der Membrantopf umfasst eine schwingungsfähige Membran und eine umlaufende Wandung sowie mindestens ein elektroakustisches Wandlerelement, wobei das Wandlerelement ausgebildet ist, die Membran zu Schwingungen anzuregen und/oder Schwingungen der Membran in elektrische Signale zu wandeln. Der Membrantopf ist aus einem Kunststoffmaterial ausgebildet, wobei erfindungsgemäß das mindestens eine Wandlerelement in die schwingungsfähige Membran integriert ist, wobei das Wandlerelement ein elektrisch aktives Polymer aufweist.

Als elektrisch aktives Polymer können beispielsweise piezoelektrische Polymere oder Piezoelektrete eingesetzt werden. Als Kunststoffmaterial des Membrantopfs inklusive der schwingfähigen Membran kann beispielsweise ein Duroplast, oder alternativ ein Thermoplast verwendet werden. Insbesondere geeignet als Kunststoffmaterialien sind Epoxidharze. Als besonders geeignete Kunststoffmaterialien sind kohle- und glasfaserverstärkte Epoxidharze zu benennen.

Durch die Integration des ein elektrisch aktives Polymer aufweisenden Wandlerelements in die schwingfähige Membran des Schallwandlers wird die elektro-mechanische Wandlung ermöglicht. Der so ausgebildete Sensor kann sowohl zum Empfang als auch zum Senden von Schall, insbesondere Ultraschall, eingesetzt werden. Die Gestaltung einer bestimmten gewünschten Schwingungsform und -frequenz kann durch geometrische Gestaltung in der Membran erreicht werden. Hierzu können beispielsweise Bereiche der Membran mit unterschiedlicher Dicke ausgebildet werden. Übliche Arbeitsfrequenzen liegen im Bereich zwischen 20 und 250 kHz, besonders gut geeignet sind Frequenzen im Bereich 30 bis 80 kHz.

Ein erfindungsgemäß ausgebildeter Schallwandler weist insbesondere den Vorteil auf, dass durch die Reduktion der Anzahl der Bauteile im Vergleich zum Stand der Technik die Herstellkosten signifikant verringert sind. Weiterhin kann in der Herstellung auf eine fehleranfällige Klebeverbindung zur Ankopplung eines separaten elektroakustischen bzw. elektromechanischen Wandlerelements an die schwingungsfähige Membran verzichtet werden. Dadurch wird der Aufbauprozess weiter vereinfacht. Ein nachträgliches Polarisieren nur eines bestimmten Bereichs der schwingungsfähigen Membran zur Ausbildung eines Wandlerelements wie aus dem Stand der Technik bekannt wird ebenfalls vermieden.

Erfindungsgemäß ausgebildete Schallwandler können so vorteilhaft Anwendung in Sensoren zur Abstandsbestimmung z.B. mittels Luftultraschall finden. Ein Einsatz zur Abstandsbestimmung in Flüssigkeiten ist ebenfalls denkbar. Durch die einteilige Ausbildung und die sich daraus ergebenden Robustheit gegenüber Umwelteinflüssen sind erfindungsgemäß ausgebildete Schallwandler besonders für den Einsatz im Automobil geeignet.

In einer besonders bevorzugten Ausführung der Erfindung sind das Gehäuse und die funktionale Gruppe des Schallwandlers einteilig bzw. als ein Bauteil ausgebildet.

Ein erfindungsgemäß ausgebildeter Schallwandler kann zur elektrischen Kontaktierung insbesondere einen oder mehrere elektrische Leiter aufweisen, wobei das Wandlerelement oder die mehreren Wandlerelemente durch den oder die elektrischen Leiter kontaktiert wird bzw. werden. Durch Anlegen von elektrischen Signalen an diese Leiter können in bekannter Weise Schwingungen des Wandlerelements angeregt werden, die auf die Membran übertragen werden und zur Abstrahlung von akustischen Signalen, insbesondere Ultraschallsignalen durch den Schallwandler führen (Sendebetrieb des Schallwandlers). Weiterhin können einfallende Schallwellen die Membran zu Schwingungen anregen, wodurch in dem Wandlerelement ein elektrisches Spannungssignal erzeugt wird, welches durch die Leiter abgegriffen wird (Empfangsbetrieb des Schallwandlers). Zur Erzeugung der elektrischen Signale zur Anregung der Membran im Sendebetrieb und/oder zur Auswertung der durch einfallende Schallwellen in dem Wandlerelement erzeugten Spannungssignale im Empfangsbetrieb können die Leiter, z.B. mittels einer Steckverbindung mit einem zur Erzeugung und/oder zur Auswertung der Signale ausgebildeten Steuergerät elektrisch verbunden sein.

Erfindungsgemäß ist mindestens ein Wandlerelement scheibenförmig ausgebildet und weist eine erste Oberfläche und eine der ersten Oberfläche gegenüberliegende zweite Oberfläche auf. Das Wandlerelement ist derart in die Membran integriert, dass die zweite Oberfläche in Richtung des Inneren des Membrantopfs freiliegt.

Diese Ausführung bietet den Vorteil, dass durch die nach Innen freiliegende zweite Oberfläche des Wandlerelements, dieses auf einfache Weise elektrisch kontaktiert werden kann. Zumindest ein elektrischer Leiter kann direkt auf der freiliegenden zweiten Oberfläche kontaktiert werden.

Erfindungsgemäß ist mindestens ein weiteres Wandlerelement scheibenförmig ausgebildet und weist eine erste Oberfläche und eine der ersten Oberfläche gegenüberliegende zweite Oberfläche auf. Das Wandlerelement ist derart in die Membran integriert ist, dass die erste Oberfläche in die Abstrahlrichtung des Membrantopfs freiliegt. Als Abstrahlrichtung wird dabei diejenige Richtung senkrecht zur Erstreckung der Membran verstanden, in die bei Anregung der Membran zu mechanischen Schwingungen ein Schallsignal bevorzugt abgestrahlt wird. Diese Anordnung des Wandlerelements hat den Vorteil einer direkten Ankopplung des piezoelektrischen Elements an das Umgebungsfluid. Dies stellt einen Vorteil besonders bei Fluiden mit niedriger Dichte dar.

Erfindungsgemäß sind mindestens zwei Wandlerelemente in die Membran integriert. Bevorzugt sind diese mindestens zwei Wandlerelemente parallel in Bezug auf die Längsachse des Membrantopfs zueinander angeordnet. Durch eine derartige mehrlagige Anordnung von Wandlerelementen kann vorteilhaft eine erhöhte Sensitivität des Schallwandlers erzielt werden. Die erhöhte Sensitivität wird beispielsweise erreicht, indem im Sendebetrieb einige oder alle der mehreren Wandlerelemente gleichzeitig beschaltet werden. Dadurch kann eine größere mechanische Spannung in der Membran erzielt werden, was zu einer erhöhten Auslenkung der Membran und damit zu einer erhöhten Sendeleistung des Schallwandlers führt. Im Empfangsbetrieb des Schallwandlers kann das empfangene Signal an zwei oder mehr Wandlerelementen abgegriffen und korreliert werden. Dadurch ergibt sich ein verbessertes Signal-Rausch-Verhältnis wodurch die Empfangsempfindlichkeit deutlich gesteigert werden kann.

Bevorzugt kann wenigstens ein Wandlerelement als vorkonfektionierte Polymerfolie ausgebildet ist. Vorkonfektioniert bedeutet in diesem Zusammenhang, dass das Wandlerelement in einer zuvor definierten Form aus einer Polymerfolie erzeugt, beispielsweise ausgeschnitten oder ausgestanzt wird. Alternativ kann ein Wandlerelement beispielsweise als vorgeformtes Bauteil umfassend einen Polymerfaserstoff ausgebildet sein.

In einer alternativen Ausführung der Erfindung ist wenigstens ein Wandlerelement durch Siebdruck, Spin-Coating oder ein Gießverfahren erzeugt. Damit lassen sich Wandlerelemente besonders dünn und/oder in besonders materialsparender Weise ausbilden.

Nach einem zweiten Aspekt der Erfindung wird ein Herstellungsverfahren für einen erfindungsgemäß ausgebildeten Schallwandler mittels Spritzguss oder Resin-Transfer-Molding angegeben.

Das Verfahren umfasst insbesondre die folgenden Schritte:
a) mindestens zwei, jeweils ein elektrisch aktives Polymer aufweisende Wandlerelemente werden in eine Kavität eines Kunststoffverarbeitungswerkzeugs eingebracht,
b) ein Kunststoffmaterial wird in die Kavität eingespritzt wird, wobei die Wandlerelemente zumindest teilweise von dem Kunststoffmaterial umschlossen werden, wodurch ein Membrantopf mit einer schwingungsfähigen Membran und einer Wandung ausgebildet wird, wobei die mindestens zwei Wandlerelemente in die schwingungsfähige Membran integriert sind.

Die erfindungsgemäßen Verfahrensschritte a) und b) müssen dabei nicht zwingend in dieser Reihenfolge ausgeführt werden. So ist es im Rahmen der Erfindung auch möglich, dass zunächst Kunststoffmaterial in die Kavität eingespritzt wird und zeitlich folgend mindestens ein ein elektrisch aktives Polymer aufweisendes Wandlerelement in eine Kavität eines Werkzeugs einer Spritzgussmaschine eingebracht wird. Bevorzugt wird jedoch zunächst das ein elektrisch aktives Polymer aufweisende Wandlerelement in die Kavität eingebracht und anschließend wird das Kunststoffmaterial eingespritzt.

Zur elektrischen Kontaktierung des Wandlerelements können elektrische Leiter (z.B. Pins) in die Kavität integriert werden. Eine weitere Variante zur elektrischen Kontaktierung des Wandlerelements besteht durch Drahtkontaktierung des Wandlerelements bevor es in die Kavität des Kunststoffverarbeitungswerkzeugs eingebracht wird.

Das erfindungsgemäße Herstellungsverfahren ermöglicht die einfache und wirtschaftliche Herstellung eines Schwallwandlers, z.B. für einen Ultraschallsensor, auf Grundlage von in die Membran integrierten, aktiven Polymeren als Wandlerelemente. Dadurch kann in der Herstellung auf eine fehleranfällige Klebeverbindung zur Ankopplung eines elektroakustischen bzw. elektro-mechanischen Wandlerelements verzichtet werden, wodurch sich ein vereinfachter Aufbauprozess ergibt. Des Weiteren kann bevorzugt die funktionale Gruppe des Schallwandlers und das Gehäuse als einteilige Gesamtkomponente in einem Arbeitsschritt gefertigt werden. Dadurch ergibt sich ein geschlossenes Bauteil mit erhöhter Robustheit gegenüber Umwelteinflüssen, wie z. B. dem Eindringen von Feuchte oder Verschmutzungen.

In einer bevorzugten Ausführung der Erfindung ist die Kavität des Kunststoffverarbeitungswerkzeugs derart ausgebildet ist, dass in Schritt b) die funktionale Gruppe einteilig mit einem Gehäuse des Schallwandlers ausgebildet wird. Durch die Einteiligkeit ergeben sich die Vorteile, dass das fertige Bauteil eine erhöhte Robustheit gegenüber Umwelteinflüssen, wie z. B. dem Eindringen von Feuchte oder Verschmutzungen aufweist, und dass außerdem Anzahl der Bauteile des Schallwandlers und Anzahl der benötigten Arbeitsschritte zum Zusammenbauen des Schallwandlers verringern.

Wie bereits erwähnt, kann mindestens ein Wandlerelement als vorkonfektionierte Polymerfolie oder vorgeformtes Bauteil umfassend einen Polymerfaserstoff ausgebildet sein. Das so ausgebildete Wandlerelement kann in Schritt a) des Verfahrens in die Kavität des Werkzeugs der Spritzgussmaschine eingelegt werden.

Alternativ oder zusätzlich kann mindestens ein Wandlerelement durch Siebdruck, Spin-Coating oder ein Gießverfahren in Schritt a) in die Kavität des Werkzeugs der Spritzgussmaschine eingebracht werden.

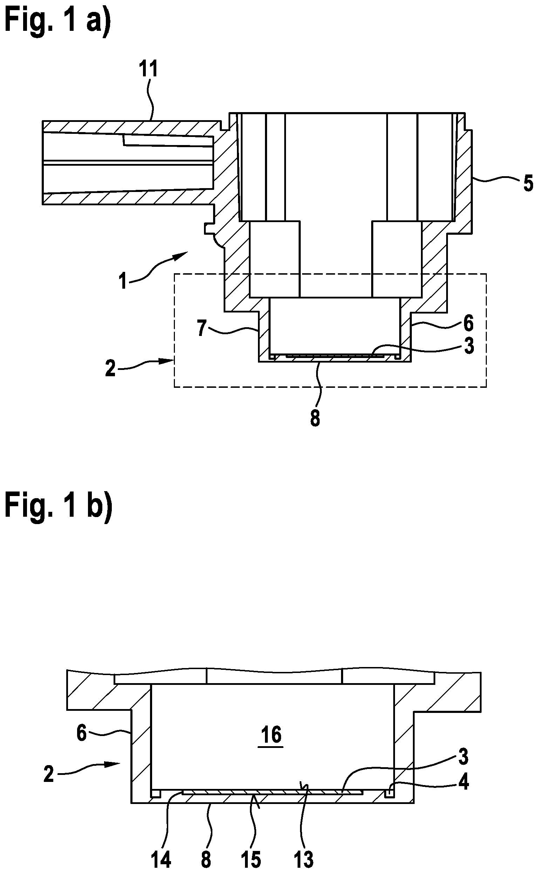

Kurze Beschreibung der Figuren
Figur 1 a) zeigt schematisch einen Schallwandler.
Figur 1 b) zeigt vergrößert die funktionale Gruppe des Schallwandlers gemäß Figur 1 a).
Figur 2 zeigt schematisch eine funktionale Gruppe eines Schallwandlers.
Figur 3 zeigt schematisch eine funktionale Gruppe eines erfindungsgemäßen Schallwandlers.
Figur 4 zeigt schematisch einen Schallwandler.
Figur 5 zeigt schematisch ein Ablaufdiagramm einer möglichen Ausführung eines erfindungsgemäßen Verfahrens.

### Ausführungsbeispiele der Erfindung

In der nachfolgenden Beschreibung der Ausführungsbeispiele der Erfindung werden gleiche Elemente mit gleichen Bezugszeichen bezeichnet, wobei auf eine wiederholte Beschreibung dieser Elemente gegebenenfalls verzichtet wird. Die Figuren stellen den Gegenstand der Erfindung nur schematisch dar.

In der Figur 1 a) ist schematisch ein Schnitt durch einen Schwallwandler 1 abgebildet. Der Schallwandler weist ein Gehäuse 5 mit einem Steckergehäuse 11 auf. Der Schwallwandler umfasst eine funktionale Gruppe 2, die einteilig mit dem Gehäuse ausgeführt ist. Die Funktionale Gruppe umfasst einen Membrantopf 6 mit einer schwingungsfähigen Membran 8 und einer umlaufenden Wandung 7. Die Membran 8 kann beispielsweise kreisförmig oder elliptisch geformt sein. Die Membran weist Bereiche 4 mit einer verringerten Dicke bzw. einer verringerten Wandstärke auf. Durch die geometrische Gestaltung dieser Bereiche werden das Schwingungsverhalten sowie die Resonanzfrequenz des Schallwandlers bestimmt. Der Membrantopf 6 ist in diesem Beispiel einteilig ausgeführt. Weiterhin geht die umlaufende Wandung 7 direkt in das Gehäuse 5 über, wobei auch das Steckergehäuse 11 einteilig mit dem Gehäuse 5 ausgeführt ist. Der Schallwandler 1 weist weiterhin ein Wandlerelement 3 auf, das ein elektrisch aktives Polymer aufweist und in die schwingungsfähige Membran 8 integriert ist.

In Figur 1 b) ist die funktionale Gruppe 2 des Schallwandlers 1 vergrößert dargestellt. Das Wandlerelement 3 ist in diesem Beispiel als Scheibe bzw. als Folie ausgebildet mit einer ersten Oberfläche 15, einer der ersten Oberfläche gegenüberliegenden zweiten Oberfläche 13 und einer umlaufenden Seitenfläche 14. Das Wandlerelement 3 ist derart in die Membran integriert, dass die zweite Oberfläche 13 in Richtung des Inneren 16 des Membrantopfs 6 freiliegt. Dabei ist das Wandlerelement 3 derart in die Membran 8 integriert, dass sowohl die erste Oberfläche 15 als auch die Seitenfläche 14 des Wandlerelements 3 vollständig vom Kunststoffmaterial der Membran 8 umschlossen sind, derart, dass die zweite Oberfläche 13 bündig mit der Membran abschließt.

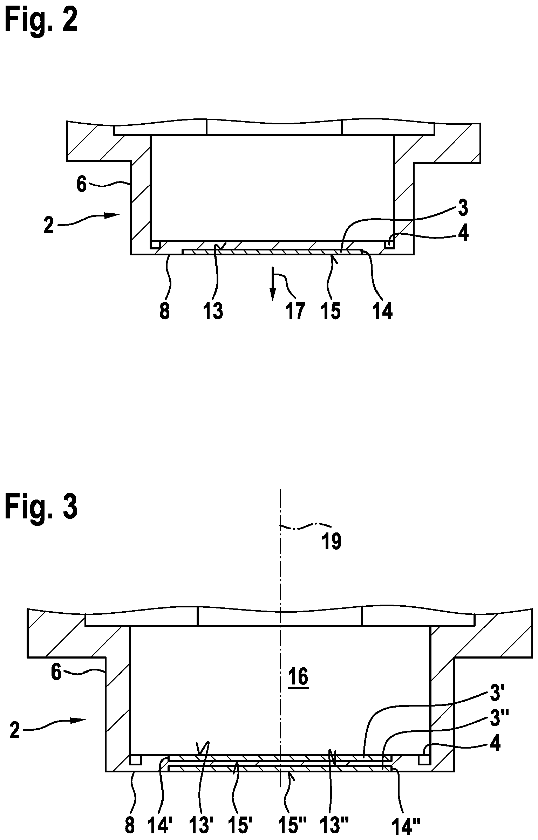

In Figur 2 ist die funktionale Gruppe 2 eines Schallwandlers 1 ebenfalls vergrößert dargestellt. Das Wandlerelement 3 ist in diesem Beispiel als Scheibe ausgebildet, mit einer ersten Oberfläche 15 und einer der ersten Oberfläche gegenüberliegenden, zweiten Oberfläche 13. Das Wandlerelement 3 ist derart in die Membran integriert, dass die erste Oberfläche 15 in Abstrahlrichtung 17 des Schallwandlers 1 freiliegt. Die elektrischen Leiter, z.B. Drähte oder Pins (nicht dargestellt) zur Kontaktierung des Wandlerelements 3 können hier beispielsweise durch das Kunststoffmaterial der Membran 8 hindurchgeführt sein.

In Figur 3 ist die funktionale Gruppe 2 des Schallwandlers 1 gemäß der Erfindung vergrößert dargestellt. In diesem Beispiel sind zwei Wandlerelemente 3', 3" in die Membran 8 integriert. Die beiden Wandlerelemente 3', 3" sind scheibenförmig mit jeweils einer ersten Oberfläche 15', 15", einer zweiten, der ersten gegenüberliegenden Oberfläche 13', 13"und einer umlaufenden Seitenfläche ausgebildet und sind mit ihren Oberflächen parallel in Bezug auf die Längsachse 19 des Membrantopfs 6 zueinander angeordnet. Dabei ist das erste Wandlerelement 3' derart in die Membran 8 integriert, dass eine zweite Oberfläche 13' in Richtung des Inneren 16 des Membrantopfs 6 freiliegt. Dabei ist das erste Wandlerelement 3' derart in die Membran 8 integriert, dass sowohl die erste Oberfläche 15' als auch die Seitenfläche 14' des Wandlerelements 3' vollständig vom Kunststoffmaterial der Membran 8 umschlossen sind, derart, dass die zweite Oberfläche 13' bündig mit der Membran 8 abschließt. Dabei ist das erste Wandlerelement 3' derart in die Membran 8 integriert, dass eine zweite Oberfläche 13' in Richtung des Inneren 16 des Membrantopfs 6 freiliegt. Das zweite Wandlerelement 3" ist derart in die Membran 8 integriert, dass das Wandlerelements 3" vollständig vom Kunststoffmaterial der Membran 8 umschlossen ist, also keine der Oberflächen 13", 15" und 14" freiliegt. Ein Ultraschallsensor, der einen Schallwandler gemäß dieser Ausführung umfasst, kann eine besonders hohe Messempfindlichkeit aufweisen. Die Wandlerelemente 3' und 3" die erfindungsgemäß ein elektrisch aktives Polymer aufweisen, können gleichartig ausgebildet sein. Es ist jedoch auch denkbar die Wandlerelemente 3' und 3" unterschiedlich auszubilden, etwa mit unterschiedlichen Materialen, geometrischen Formen und/oder Materialstärken.

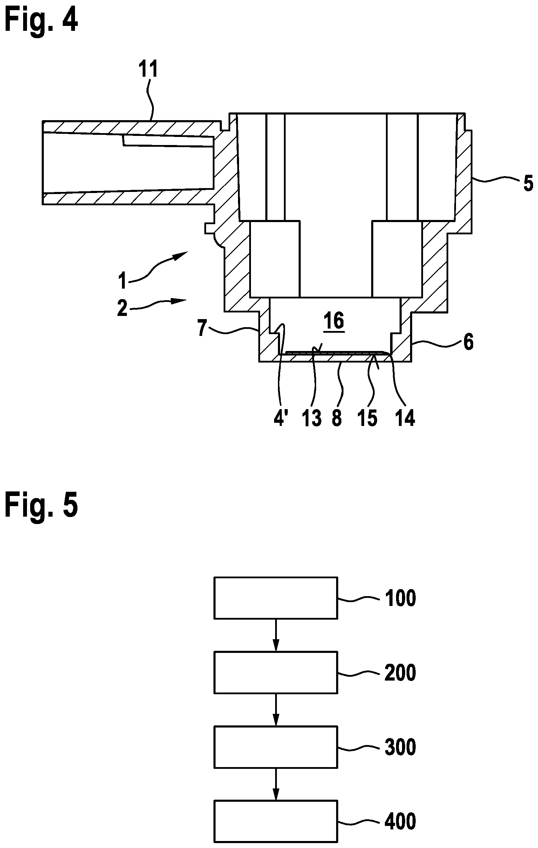

In der Figur 4 ist schematisch ein Schnitt durch einen Schwallwandler 1 abgebildet. Der Schallwandler weist wiederum ein Gehäuse 5 mit einem Steckergehäuse 11 auf. Der Schwallwandler umfasst eine funktionale Gruppe 2, die einteilig mit dem Gehäuse ausgeführt ist. Die Funktionale Gruppe umfasst einen Membrantopf 6 mit einer schwingungsfähigen Membran 8 und einer umlaufenden Wandung 7. Der Schallwandler 1 weist weiterhin ein Wandlerelement 3 auf, das als piezokeramisches Element ausgebildet ist und in die schwingungsfähige Membran 8 integriert ist. Das Wandlerelement 3 ist auch in diesem Beispiel als Scheibe ausgebildet mit einer ersten Oberfläche 15, einer der ersten Oberfläche gegenüberliegenden zweiten Oberfläche 13 und einer umlaufenden Seitenfläche 14. Das Wandlerelement 3 ist derart in die Membran integriert, dass die zweite Oberfläche 13 in Richtung des Inneren 16 des Membrantopfs 6 freiliegt. Dabei ist die Seitenfläche 14 nur teilweise oder gar nicht vom Kunststoffmaterial der Membran 8 umschlossen. Daraus ergeben sich mögliche Vorteile für den Herstellungsprozess. Alternativ kann das

Wandlerelement 3 auch wie in Figur 1 und 2 dargestellt, so in die Membran integriert sein, dass nur eine Oberfläche 13 oder 15 freiliegt. Bereiche 4' der Membran weisen eine erhöhte Dicke (Materialanhäufung) auf. Durch die Ausgestaltung der Bereiche 4' kann die Resonanzfrequenz des Schallwandlers sowie die Richtcharakteristik des Schallwandlers angepasst werden. Die Bereiche 4' können dabei gleichmäßig (symmetrisch) oder ungleichmäßig (asymmetrisch) angeordnet sein.

Figur 5 stellt den Ablauf eines erfindungsgemäßen Herstellungsverfahrens für eine funktionale Gruppe eines erfindungsgemäßen Schallwandlers dar.

In Schritt 100 wird ein Kunststoffverarbeitungswerkzeug mit einer Kavität bereitgestellt, deren Form der gewünschten Form des Schallwandlers angepasst ist.

In Schritt 200 werden mindestens zwei, jeweils ein elektrisch aktives Polymer aufweisende Elemente, die als Wandlerelemente (3', 3") vorgesehen sind, in die Kavität eingebracht. Optional können bereits elektrische Leiter vorgesehen werden, die die Elektroden der Wandlerelemente kontaktieren.

In Schritt 300 wird ein Kunststoffmaterial, beispielsweise ein Epoxidharz in die Kavität eingespritzt, wodurch zumindest die funktionale Gruppe des Schallwandlers ausgebildet wird und wodurch die Wandlerelemente zumindest teilweise von dem Kunststoffmaterial umschlossen werden. Ist die Kavität entsprechend ausgestaltet kann nicht nur die funktionale Gruppe des Schallwandlers, sondern auch das Gehäuse in einem Bauteil ausgebildet werden.

In Schritt 400 wird, gegebenenfalls nach einer Erstarrungsdauer, die funktionale Gruppe bzw. das Bauteil umfassend die funktionale Gruppe und das Gehäuse des Schallwandlers entnommen.

## Patentansprüche

1. Schallwandler (1) für einen Ultraschallsensor, aufweisend eine funktionale Gruppe (2), wobei die funktionale Gruppe (2) einen Membrantopf (6) und mindestens zwei elektroakustische Wandlerelemente (3', 3") umfasst, und ein Gehäuse (5), wobei der Membrantopf (6) eine schwingungsfähige Membran (8) und eine Wandung (7) aufweist, wobei die Wandlerelemente (3', 3") ausgebildet sind, die Membran (8) zu Schwingungen anzuregen und/oder Schwingungen der Membran (8) in elektrische Signale zu wandeln und wobei zumindest der Membrantopf (6) aus einem Kunststoffmaterial ausgebildet ist,
wobei die mindestens zwei Wandlerelemente (3', 3") in die schwingungsfähige Membran (8) integriert sind und wobei die Wandlerelemente (3', 3") jeweils ein elektrisch aktives Polymer aufweisen **dadurch gekennzeichnet, dass** mindestens ein Wandlerelement (3') scheibenförmig ausgebildet ist und eine erste Oberfläche (15) und eine der ersten Oberfläche (15) gegenüberliegende zweite Oberfläche (13) aufweist, wobei dieses Wandlerelement (3') derart in die Membran (8) integriert ist, dass die zweite Oberfläche (13) in Richtung des Inneren (16) des Membrantopfs (6) freiliegt und wobei mindestens ein weiteres Wandlerelement (3") im Wesentlichen scheibenförmig ausgebildet ist und eine erste Oberfläche (15) und eine der ersten Oberfläche (15) gegenüberliegende zweite Oberfläche (13) aufweist, wobei dieses weitere Wandlerelement (3") derart in die Membran (8) integriert ist, dass die erste Oberfläche (15) in die Abstrahlrichtung (17) des Membrantopfs (6) freiliegt.

2. Schallwandler nach Anspruch 1, **dadurch gekennzeichnet, dass** der Schallwandler (1) ein oder mehrere elektrische Leiter aufweist, wobei die Wandlerelemente (3', 3") durch den oder die elektrischen Leiter kontaktiert werden.

3. Schallwandler nach Anspruch 1 oder 2, **dadurch gekennzeichnet, dass** die mindestens zwei Wandlerelemente (3', 3") parallel in Bezug auf die Längsachse (19) des Membrantopfs (6) zueinander angeordnet sind.

4. Schallwandler nach einem der Ansprüche 1 bis 3 **dadurch gekennzeichnet, dass** das Gehäuse (5) und die funktionale Gruppe (2) einteilig ausgebildet sind.

5. Schallwandler nach einem der Ansprüche 1 bis 4, **dadurch gekennzeichnet, dass** wenigstens ein Wandlerelement (3) als vorkonfektionierte Polymerfolie oder vorgeformtes Bauteil umfassend einen Polymerfaserstoff ausgebildet ist.

6. Schallwandler nach einem der Ansprüche 1 bis 5, **dadurch gekennzeichnet, dass** wenigstens ein Wandlerelement (3) durch Siebdruck, Spin-Coating oder ein Gießverfahren erzeugt ist.

7. Schallwandler nach einem der Ansprüche 1 bis 6, **dadurch gekennzeichnet, dass** die schwingungsfähige Membran (8) Bereiche (4) mit reduzierter Dicke und/oder Bereiche (4') mit erhöhter Dicke aufweist.

8. Verfahren zum
Herstellen einer funktionalen Gruppe (2) eines Schallwandlers (1) nach einem der Ansprüche 1 bis 7, wobei
a. mindestens zwei, jeweils ein elektrisch aktives Polymer aufweisende Wandlerelemente (3', 3") in eine Kavität eines Werkzeugs einer Spritzgussmaschine eingebracht werden,
b. ein Kunststoffmaterial in die Kavität eingespritzt wird, wobei die Wandlerelemente (3', 3") zumindest teilweise von dem Kunststoffmaterial umschlossen werden, wodurch ein Membrantopf (6) mit einer schwingungsfähigen Membran (8) und einer Wandung (7) ausgebildet wird, wobei die mindestens zwei Wandlerelemente (3', 3") in die schwingungsfähige Membran (8) integriert sind.

9. Verfahren nach Anspruch 8, **dadurch gekennzeichnet, dass** die Kavität des Werkzeugs der Spritzgussmaschine derart ausgebildet ist, dass in Schritt b) die funktionale Gruppe (2) einteilig mit einem Gehäuse (5) des Schallwandlers (1) ausgebildet wird.

10. Verfahren nach einem der Ansprüche 8 oder 9, **dadurch gekennzeichnet, dass** mindestens ein Wandlerelement (3) als vorkonfektionierte Polymerfolie oder vorgeformtes Bauteil umfassend einen Polymerfaserstoff ausgebildet ist und in Schritt a) in die Kavität des Werkzeugs der Spritzgussmaschine eingelegt wird.

11. Verfahren nach einem der Ansprüche 8 oder 9, **dadurch gekennzeichnet, dass** mindestens ein Wandlerelement (3) durch Siebdruck, Spin-Coating oder ein Gießverfahren in Schritt a) in die Kavität des Werkzeugs der Spritzgussmaschine eingebracht wird.

12. Ultraschallsensor mit einem Schallwandler (1) nach einem der Ansprüche 1 bis 7.

## Claims

1. Sound transducer (1) for an ultrasound sensor, having a functional group (2), wherein the functional group (2) comprises a diaphragm pot (6) and at least two electroacoustic transducer elements (3', 3''), and a housing (5), wherein the diaphragm pot (6) has a vibratory diaphragm (8) and a wall (7), wherein the transducer elements (3', 3") are designed to excite the diaphragm (8) to vibrate and/or to convert vibrations of the diaphragm (8) into electrical signals and wherein at least the diaphragm pot (6) is formed from a plastic material,
wherein the at least two transducer elements (3', 3") are integrated into the vibratory diaphragm (8) and wherein the transducer elements (3', 3") each have an electrically active polymer,
**characterized in that** at least one transducer element (3') is of disc-like design and has a first surface (15) and a second surface (13) opposite the first surface (15), wherein this transducer element (3') is integrated into the diaphragm (8) in such a way that the second surface (13) is exposed in the direction of the interior (16) of the diaphragm pot (6) and wherein at least one further transducer element (3") is of substantially disc-like design and has a first surface (15) and a second surface (13) opposite the first surface (15), wherein this further transducer element (3") is integrated into the diaphragm (8) in such a way that the first surface (15) is exposed in the emission direction (17) of the diaphragm pot (6).

2. Sound transducer according to Claim 1, **characterized in that** the sound transducer (1) has one or more electrical conductors, wherein the transducer elements (3', 3") are contacted by the electrical conductor or conductors.

3. Sound transducer according to Claim 1 or 2, **characterized in that** the at least two transducer elements (3', 3") are arranged parallel to one another in relation to the longitudinal axis (19) of the diaphragm pot (6).

4. Sound transducer according to one of Claims 1 to 3, **characterized in that** the housing (5) and the functional group (2) are formed in one piece.

5. Sound transducer according to one of Claims 1 to 4, **characterized in that** at least one transducer element (3) is formed as a prefabricated polymer film or preformed component comprising a polymer fibre material.

6. Sound transducer according to one of Claims 1 to 5, **characterized in that** at least one transducer element (3) is produced by screen printing, spin coating or a casting method.

7. Sound transducer according to one of Claims 1 to 6, **characterized in that** the vibratory diaphragm (8) has areas (4) of reduced thickness and/or areas (4') of increased thickness.

8. Method for producing a functional group (2) of a sound transducer (1) according to one of Claims 1 to 7, wherein
a. at least two transducer elements (3', 3"), each having an electrically active polymer, are introduced into a cavity of a mould of an injection-moulding machine,
b. a plastic material is injected into the cavity, wherein the transducer elements (3', 3") are at least partially enclosed by the plastic material, as a result of which a diaphragm pot (6) with a vibratory diaphragm (8) and a wall (7) is formed, wherein the at least two transducer elements (3', 3") are integrated into the vibratory diaphragm (8).

9. Method according to Claim 8, **characterized in that** the cavity of the mould of the injection-moulding machine is formed in such a way that, in step b), the functional group (2) is formed in one piece with a housing (5) of the sound transducer (1).

10. Method according to either of Claims 8 and 9, **characterized in that** at least one transducer element (3) is formed as a prefabricated polymer film or preformed component comprising a polymer fibre material and, in step a), is inserted into the cavity of the mould of the injection-moulding machine.

11. Method according to either of Claims 8 and 9, **characterized in that**, in step a), at least one transducer element (3) is introduced into the cavity of the mould of the injection-moulding machine by screen printing, spin coating or a casting method.

12. Ultrasound sensor having a sound transducer (1) according to one of Claims 1 to 7.

## Revendications

1. Transducteur acoustique (1) pour un capteur à ultrasons, présentant un groupe fonctionnel (2), le groupe fonctionnel (2) comprenant un pot à membrane (6) et au moins deux éléments transducteurs électroacoustiques (3', 3"), et un boîtier (5), le pot à membrane (6) présentant une membrane oscillante (8) et une paroi (7), les éléments transducteurs (3', 3") étant réalisés pour faire osciller la membrane (8), et/ou pour transformer des oscillations de la membrane (8) en signaux électriques, et au moins le pot à membrane (6) étant réalisé en matière plastique,
les au moins deux éléments transducteurs (3', 3") étant intégrés dans la membrane oscillante (8), et les éléments transducteurs (3', 3") présentant respectivement un polymère électroactif,
**caractérisé en ce qu'**au moins un élément transducteur (3') est réalisé en forme de disque et présente une première surface (15) et une deuxième surface (13) opposée à la première surface (15), cet élément transducteur (3') étant intégré à la membrane (8) de telle sorte que la deuxième surface (13) est exposée en direction de l'intérieur (16) du pot à membrane (6), et au moins un autre élément transducteur (3") étant réalisé substantiellement en forme de disque et présentant une première surface (15) et une deuxième surface (13) opposée à la première surface (15), cet autre élément transducteur (3") étant intégré à la membrane (8) de telle sorte que la première surface (15) est exposée dans la direction d'émission (17) du pot à membrane (6).

2. Transducteur acoustique selon la revendication 1, **caractérisé en ce que** le transducteur acoustique (1) présente un ou plusieurs conducteurs électriques, les éléments transducteurs (3', 3") étant mis en contact par le ou les conducteurs électriques.

3. Transducteur acoustique selon la revendication 1 ou 2, **caractérisé en ce que** les au moins deux éléments transducteurs (3', 3") sont disposés en parallèle l'un à l'autre par rapport à l'axe longitudinal (19) du pot à membrane (6).

4. Transducteur acoustique selon l'une quelconque des revendications 1 à 3, **caractérisé en ce que** le boîtier (5) et le groupe fonctionnel (2) sont réalisés d'un seul tenant.

5. Transducteur acoustique selon l'une quelconque des revendications 1 à 4, **caractérisé en ce qu'**au moins un élément transducteur (3) est réalisé sous la forme d'un film polymère préconfectionné ou d'un composant préconfectionné comprenant une matière fibreuse polymère.

6. Transducteur acoustique selon l'une quelconque des revendications 1 à 5, **caractérisé en ce qu'**au moins un élément transducteur (3) est produit par sérigraphie, par enduction centrifuge ou par un procédé de moulage.

7. Transducteur acoustique selon l'une quelconque des revendications 1 à 6, **caractérisé en ce que** la membrane oscillante (8) présente des zones (4) d'épaisseur réduite et/ou des zones (4') d'épaisseur augmentée.

8. Procédé de fabrication d'un groupe fonctionnel (2) d'un transducteur acoustique (1) selon l'une quelconque des revendications 1 à 7, dans lequel
a. au moins deux éléments transducteurs (3', 3"), présentant respectivement un polymère électroactif, sont introduits dans une cavité d'un moule d'une machine de moulage par injection,
b. une matière plastique est injectée dans la cavité, les éléments transducteurs (3', 3") étant entourés au moins en partie par la matière plastique, de façon à réaliser un pot à membrane (6) doté d'une membrane oscillante (8) et d'une paroi (7), les au moins deux éléments transducteurs (3', 3") étant intégrés à la membrane oscillante (8).

9. Procédé selon la revendication 8, **caractérisé en ce que** la cavité du moule de la machine de moulage par injection est réalisée de telle sorte qu'à l'étape b) le groupe fonctionnel (2) est réalisé d'un seul tenant avec un boîtier (5) du transducteur acoustique (1).

10. Procédé selon l'une quelconque des revendications 8 ou 9, **caractérisé en ce qu'**au moins un élément transducteur (3) est réalisé sous la forme d'un film polymère préconfectionné ou d'un composant préconfectionné comprenant une matière fibreuse polymère, et est inséré à l'étape a) dans la cavité du moule de la machine de moulage par injection.

11. Procédé selon l'une quelconque des revendications 8 ou 9, **caractérisé en ce qu'**au moins un élément transducteur (3) produit par sérigraphie, par enduction centrifuge ou par un procédé de moulage à l'étape a) est introduit dans la cavité du moule de la machine de moulage par injection.

12. Capteur à ultrasons, comprenant un transducteur acoustique (1) selon l'une quelconque des revendications 1 à 7.
